# EUROPEAN PATENT APPLICATION

(11) **EP 2 213 765 A1**
(43) Date of publication of application: **04.08.2010**
(21) Application number: 09150785.5
(22) Date of filing: 16.01.2009
(51) Int. Cl.: C23C 14/56, C23C 14/18, H01J 37/34, H01J 37/32, C03C 17/00, C03C 17/09, C03C 17/36, H01L 31/18, H01L 21/677

(54) **Stray coating prevention device, coating chamber device for coating substrates, and method of coating**

(71) Applicant: Applied Materials, Inc., Santa Clara, CA 95054 (US)
(72) Inventor: Bloemers, Hugo, Whitley Bay, NE 25-8LX (GB)
(74) Representative: Zimmermann & Partner

(57) **Abstract**

A stray coating prevention device adapted for a coating chamber for coating substrates, said coating chamber including a coating device for dispensing coating material into the coating chamber; a substrate support adapted to support one or more substrates on a support plane, the substrates each having a backside, the support plane dividing the coating chamber into a rear part and a front part of the coating chamber, and the coating device being located in the front part of the coating chamber; wherein the stray coating prevention device comprises a plurality of adsorption traps, the adsorption traps being provided at a surface of the rear part of the coating chamber.

## Description

### TECHNICAL FIELD OF THE INVENTION

Embodiments described herein relate to a stray coating prevention device, a coating chamber for coating substrates, and a method of coating. Particularly, embodiments relate to a stray coating prevention device for a coating chamber for coating substrates, a coating chamber for coating substrates, and a method of coating one or more substrates in a coating chamber.

### BACKGROUND OF THE INVENTION

Thin-film coating of material on plate-shaped substrates may be accomplished in many ways, for example by evaporation or sputtering of the coating material. In some instances, for example in the manufacture of solar cells, it is desirable to coat exclusively one surface of the plate-shaped substrates.

In known installations for coating continuously conveyed plate-shaped substrates, typically glass substrates, with thin layers by cathode sputtering, several compartments are located one after another. Each compartment includes at least one sputtering cathode and process gas inlets, and is connected with a vacuum pump for evacuation. The compartments are connected to one another by means of openings, typically vacuum locks or airlocks, which may include one or more slit valves. A transport system including transport rolls for transporting the plate-shaped substrates along a path in front of, e.g. below, the sputtering cathodes and passing the substrates through the openings between the compartments is provided.

When operating a sputtering cathode, plasma is established and ions of the plasma are accelerated onto a target of coating material to be deposited onto the substrates. This bombardment of the target results in ejection of atoms of the coating material which accumulate as a deposited film on the substrate below the sputtering cathode.

In known designs of a compartment for coating substrates, e.g. continuously transported rectangular plate-shaped substrates, coating material may deposit not only on the front sides of the substrates as desired, but also on areas on which coating is undesired, such as the backsides of the substrates. Undesired coating may for instance be caused by atoms which are projected towards components of the compartment, e.g. a side wall, and bounce back and/or are deflected from the surfaces of these components, resulting in a so called stray coating. This stray coating may cause deposition of coating material on other areas of the substrates than the areas on which coating is intended. For instance during coating of glass substrates for solar cells, coating of the backsides of the substrates is especially undesirable.

### SUMMARY

In light of the above, the stray coating prevention device according to independent claim 1, the coating chamber device according to independent claim 5, the method of coating one or more substrates in a coating chamber according to claim 12, and the method of coating one or more substrates in a coating chamber according to claim 13 are provided.

In one embodiment, a stray coating prevention device adapted for a coating chamber for coating substrates is provided, said coating chamber including a coating device adapted for dispensing coating material into the coating chamber; a substrate support adapted to support one or more substrates on a support plane, the substrates each having a backside, the support plane dividing the coating chamber into a rear part and a front part of the coating chamber, and the coating device being located in the front part of the coating chamber; wherein the stray coating prevention device includes a plurality of adsorption traps, the adsorption traps being adapted to be provided at a surface of the coating chamber.

In a further embodiment, a coating chamber for coating substrates is provided, including a coating device adapted for dispensing coating material into the coating chamber; a substrate support adapted to support one or more substrates on a support plane, the substrates each having a backside, the support plane dividing the coating chamber into a rear part and a front part of the coating chamber, and the coating device being located in the front part of the coating chamber; and a stray coating prevention device including a plurality of adsorption traps, the adsorption traps being provided at at least one element selected from the group consisting of a surface of the coating chamber and a surface of the rear part of the coating chamber.

In another embodiment, a method of coating one or more substrates in a coating chamber is provided, including providing a substrate on a substrate support of the coating chamber, the coating chamber being provided with a stray coating prevention device including a plurality of adsorption traps, the adsorption traps being provided at a surface of the coating chamber; and dispensing coating material from a coating device provided in the coating chamber towards the substrate and simultaneously preventing stray coating of the substrate by the stray coating prevention device.

In yet another embodiment, a method of coating one or more substrates in a coating chamber is provided, including providing a substrate on a substrate support of the coating chamber, the coating chamber including a coating device adapted for dispensing coating material into the coating chamber and a substrate support adapted to support one or more substrates on a support plane, the substrates each having a backside, the support plane dividing the coating chamber into a rear part and a front part of the coating chamber, and the coating device being located in the front part of the coating chamber; the coating chamber being provided with a stray coating prevention device including a plurality of adsorption traps, the adsorption traps being provided at a surface of the rear part of the coating chamber; and dispensing coating material from the coating device towards the substrate and simultaneously preventing backside coating of the substrate by the stray coating prevention device.

In a yet further embodiment, a method of coating one or more substrates in a coating chamber is provided, including providing the coating chamber, the coating chamber being provided with a stray coating prevention device including a plurality of adsorption traps, the adsorption traps being provided at a surface of the coating chamber; providing a substrate on the substrate support of the coating chamber; and dispensing coating material from the coating device provided in the coating chamber towards the substrate and simultaneously preventing stray coating of the substrate by the stray coating prevention device.

In one embodiment, a method of coating one or more substrates in a coating chamber is provided, including providing the coating chamber, the coating chamber including a coating device adapted for dispensing coating material into the coating chamber and a substrate support adapted to support one or more substrates on a support plane, the substrates each having a backside, the support plane dividing the coating chamber into a rear part and a front part of the coating chamber, and the coating device being located in the front part of the coating chamber; the coating chamber being provided with a stray coating prevention device including a plurality of adsorption traps, the adsorption traps being provided at a surface of the rear part of the coating chamber; providing a substrate on the substrate support, dispensing coating material from the coating device towards the substrate, and simultaneously preventing backside coating of the substrate by the stray coating prevention device.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

It is contemplated that elements of one embodiment may be advantageously utilized in other embodiments without further recitation.

### BRIEF DESCRIPTION OF THE DRAWINGS

So that the manner in which the above recited features of the present invention can be understood in detail, a more particular description of embodiments of the invention, briefly summarized above, may be had by reference to embodiments. The accompanying drawings relate to embodiments of the invention and are described in the following. Some of the above mentioned embodiments will be described in more detail in the following description of typical embodiments with reference to the following drawings in which:

Fig. 1 shows a cross-sectional view of a coating chamber including a stray coating prevention device according to embodiments described herein;

Fig. 2 is a cross-sectional view of the coating chamber along line A-A shown in Fig. 1;

Fig. 3 shows an enlarged view of the coating chamber shown in Fig. 2 illustrating the area between a sidewall of the coating chamber and a substrate positioned therein;

Fig. 4 is a flow diagram of a coating method according to embodiments described herein;

Fig. 5 illustrates one example of a stray coating prevention device according to an embodiment described herein;

Fig. 6 is a schematic illustration of the effect of the example shown in Figs. 1 and 5;

Fig. 7 shows another example of a stray coating prevention device according to an embodiment described herein; and

Fig. 8 shows a further example of a stray coating prevention device according to an embodiment described herein.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

A typical application of the stray coating prevention device, the coating chamber and the coating method of embodiments described herein is in PVD (Physical Vapor Deposition) compartments, e.g. vacuum sputtering compartments, of coating installations. The stray coating prevention device particularly may be utilized in installations for coating continuously or discontinuously conveyed plate-shaped substrates with thin films. Embodiments described herein are especially useful when coating glass substrates, e.g. plate-shaped glass substrates, with thin metal films, for example with Ag films, for instance in the manufacture of solar cells.

Without limiting the scope, the following is directed to a stray coating prevention device for avoiding backside coating of a substrate in a vacuum sputtering coating chamber for thin-film Ag coating of continuously transported rectangular plate-shaped glass substrates. However, the stray coating prevention device may also be used for avoiding stray coating of other areas of the substrate than the backside. Embodiments can also be applied to other coating methods, such as thin-film vapor deposition, and other coating materials than Ag, e.g. other metals or alloys, such as Al. Furthermore, other substrates, such as a web or plastic films, having modified shapes may be employed. Moreover, the substrate(s) may be delivered to the coating chamber continuously or may be provided in the coating chamber in a discontinuous mode. In addition, the coating chamber is not limited to a vacuum chamber.

The term "particle" as used herein may, without limiting the scope, include at least one element selected from the group consisting of evaporated particles, sputtered particles, positively charged particles, negatively charged particles, positive and/or negative ions, electrons, neutral atoms, charged atoms, clusters of neutral atoms, clusters of charged atoms, neutral molecules and charged molecules.

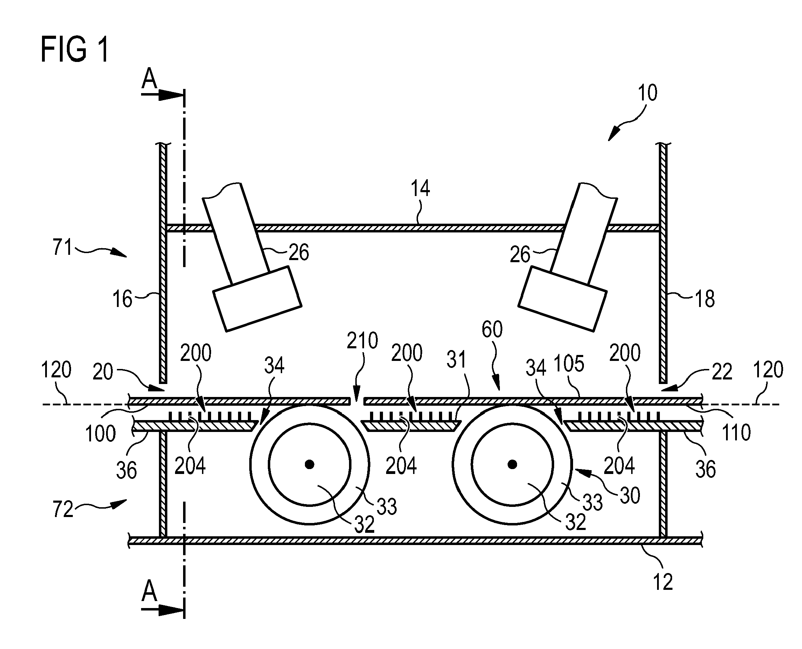

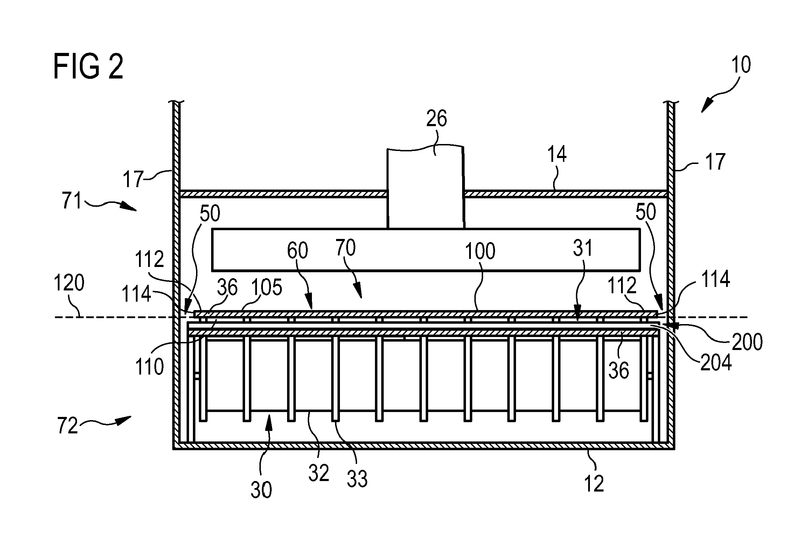

Fig. 1 illustrates a cross-sectional view of a coating chamber 10 designed as a vacuum sputtering chamber for thin-film coating of continuously transported rectangular plate-shaped glass substrates 100. The coating chamber 10 includes a backside coating prevention device 200 according to embodiments described herein. Fig. 2 shows a cross-sectional view of the coating chamber 10 according to Fig. 1, along line A-A. The coating chamber 10 includes a bottom wall 12, a top wall 14, a front wall 16, a rear wall 18 and two sidewalls 17. The material of all walls is stainless steel and the coating chamber 10 is vacuum-tight. The front wall 16 includes a substrate feeding opening 20 and the rear wall 18 includes a substrate discharge opening 22. The substrate feeding and discharge openings 20, 22 are designed as vacuum locks or airlocks, typically as slit valves, for maintaining a vacuum in the coating chamber 10 when feeding and discharging the glass substrates 100. The coating chamber 10 further has process gas inlets (not shown) and is connected to vacuum pumps (not shown) for establishing a vacuum of about 10⁻⁶ Torr. The pressure value of 10⁻⁶ Torr should, of course, be understood as an example while other pressure values or ranges are also applicable. For example, a typical pressure range for sputtering is between 10⁻³ hPa to 10⁻² hPa, a typical pressure range for evaporation is from lower than 10⁻⁶ hPa to 10⁻³ hPa, more typically in the range from 10⁻⁵ hPa to 10⁻⁴ hPa. Furthermore, at the top wall 14 one or more, typically two, sputtering cathodes 26 each including a target of Ag are provided as coating device adapted for dispensing coating material into the coating chamber.

On the bottom wall 12, as a substrate support, a transport system 30 for continuously conveying a plurality of glass substrates 100 is mounted, as is shown in Fig. 1 and 2, especially in Fig. 2. The transport system 30 has a front side 31 facing the sputtering cathode 26 and is adapted for supporting on the front side 31 one or more plate-shaped glass substrates 100. The transport system 30 includes a plurality of, typically two, rotatable rolls 32 arranged in parallel to each other throughout the coating chamber 10 successively from the front wall 16 to the rear wall 18. The rolls 32 extend from one sidewall 17 to the opposite sidewall 17. Furthermore, each roll 32 is positioned below a cover panel 36 of the transport system 30 and includes a plurality of spaced apart rings 33 being each concentrically attached to the roll 32. The rings 33 extend through openings 34 in the cover panel 36 of the transport system 30 and support the glass substrates 100 and, thereby, define a substrate support plane 120 above the cover panel 36. The substrate support plane 120 is shown in Figs. 1 and 2 as a dashed line and divides the coating chamber 10 into a front part 71 and a rear part 72. Front sides 105 of the glass substrates 100 supported on the rings 33 face the sputtering cathodes 26. The cover panel 36 is disposed at a front side 105 of the transport system and has an installation height such that it is positioned typically about 6 mm to about 12 mm beneath the substrate support plane 120. Furthermore, the distance between cover panel 36 and substrate support plane 120 defines a space below the substrate support plane.

In an alternative design (not shown in the Figures) of the transport system, the diameter of the plurality of rolls may be much smaller than the diameter of the plurality of rings. Each ring may then be attached to a wheel which is attached to one of the rolls. Hence, each roll may have a plurality of spaced apart wheels being each concentrically attached to the roll. Each wheel may support one ring at the outermost circumference of the wheel. The rings support the glass substrates 100 and, thereby, define the substrate support plane 120, also referred to herein as support plane 120, at the front side 31 of the substrate support.

The rolls 32 are connected to a driving unit (not shown), which is connected to a control unit (not shown). The transport system 30 is made for conveying the plate-shaped glass substrates 100 in a transport direction along a transport path 60. The transport path 60 is defined by the transported glass substrates 100 and is positioned on the substrate support plane 120 below the sputtering cathodes 26 and through the substrate feeding and discharge openings 20, 22 of the coating chamber 10. During coating operation, the transport path 60 extends from the substrate feeding opening 20 to the substrate discharge opening 22.

As shown in e.g. Fig. 2, each glass substrate 100 has one front side 105 to be coated and facing the sputtering cathodes 26 during transport of the glass substrate on the transport system 30. Each glass substrate 100 further includes a backside 110 opposite to the front side 105 and facing the transport system 30 during transport of the glass substrate thereon, and two lateral ends 112 each including a lateral side 114. During transport of the glass substrates 100, as illustrated in Fig. 1, gaps 210 are formed between successively transported rectangular plate-shaped glass substrates 100 on the transport system 30. The gaps 210 extend across the full width of the transport path 60.

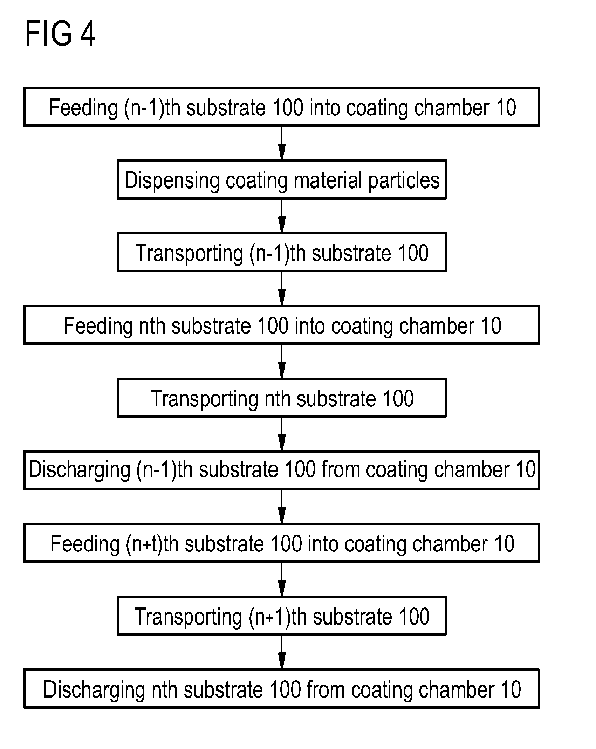

The following is an example of a coating method according to embodiments described herein, the beginning of which is shown schematically in Fig. 4. A front end of a first glass substrate 100 ((n-1)th glass substrate; n being an integer ≥ 2) enters the coating chamber 10. The sputtering cathodes 26 are then switched on or, alternatively, are already working. The first glass substrate 100 is continuously transported below the operating sputtering cathodes 26 and through the coating chamber 10 while being coated on its front side 105 with Ag particles. After the rear end of the first glass substrate 100 has entered the coating chamber 10, the front end of a second (nth) glass substrate 100 is fed into the coating chamber 10 through the substrate feeding opening 20. The second glass substrate 100 is arranged on the rings 33 of the transport system 30 and transported thereon. Again, the second glass substrate 100 is continuously transported below the operating sputtering cathodes 26 and through the coating chamber 10 while being coated on its front side 105 with Ag particles. During conveying of the second glass substrate 100, after a first and a second period of time, the front end and the rear end of the continuously transported first glass substrate 100 consecutively arrive at and are discharged through the discharge opening 22. The first and the second periods of time depend on the length, i.e. the distance between the front and the rear ends, of the first glass substrate 100, as the skilled person is aware. Thereafter, the front end of the second glass substrate 100 arrives at the substrate discharge opening 22 and is discharged from the coating chamber 10. Finally, after a period of time depending on the length of the second glass substrate 100, its rear end is discharged through the substrate discharge opening 22, thus completing the process of coating the second glass substrate 100

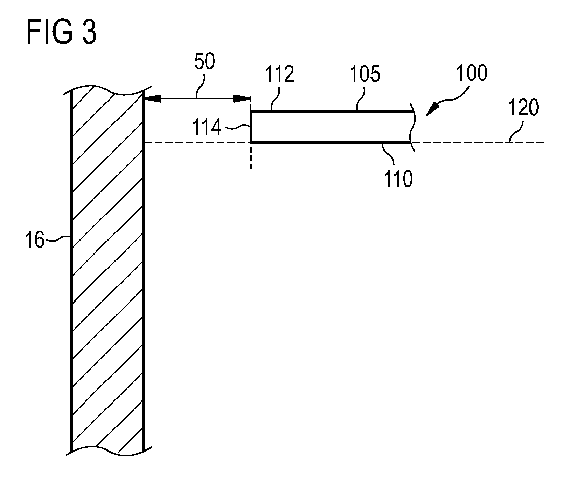

Typically, when coating a plurality of successively transported substrates, an efficient way of operating the sputtering cathodes is a continuous mode, such as described above referring to Fig. 4. Ag particles, which are sputtered in the coating chamber 10 by the sputtering cathodes 26 towards the glass substrates 100, move along straight trajectories and may also be deflected by collisions with other particles or with the walls of the coating chamber 10. A number of the Ag coating material particles which travel to the front sides 105 of the glass substrates 100 may pass the gaps 210 between successively transported rectangular plate-shaped glass substrates 100 and may undesirably be deposited on the backsides 110 of the glass substrates 100 by stray coating after bouncing back, e.g. from the cover panel 36. Moreover, lateral gaps 50 are formed between the lateral sides 114 of successively transported rectangular plate-shaped glass substrates 100 and the sidewalls 17 of the coating chamber 10, as shown in Figs. 2 and 3. Therefore, the sputtered Ag particles may also pass the lateral gaps 50 and may be deposited on the backsides 110 of the glass substrates 100 by stray coating, after bouncing back from and/or being deflected from surfaces in the rear part of the coating chamber 10, e.g. from the cover panel 36. The bouncing or deflected Ag particles may even be ballistically projected. Another reason for undesired backside coating may be that the plasma produced during sputtering operation wraps around the edges of the substrates and thereby directs Ag particles in the rear part of the coating chamber. Stray coating may for instance cause deposition of Ag particles at the outer perimeter of the backsides 110 of the substrates 100, e.g. up to 20 mm inwards.

Typically, as mentioned above, stray coating may be caused by atoms which are projected towards components of the coating chamber 10, e.g. a side wall 16 or the cover panel 36, and bounce back and/or are deflected from the surfaces of these components. This stray coating may cause deposition of coating material on other areas of the substrates than the areas on which coating is intended.

Therefore, in one embodiment described herein, a stray coating prevention device adapted for a coating chamber for coating substrates is provided, said coating chamber including a coating device adapted for dispensing coating material into the coating chamber; a substrate support adapted to support one or more substrates on a support plane, the substrates each having a backside, the support plane dividing the coating chamber into a rear part and a front part of the coating chamber, and the coating device being located in the front part of the coating chamber; wherein the stray coating prevention device includes a plurality of adsorption traps, the adsorption traps being adapted to be provided at a surface of the coating chamber.

Moreover, according to another embodiment, a coating chamber for coating substrates is provided, including a coating device adapted for dispensing coating material into the coating chamber; a substrate support adapted to support one or more substrates on a support plane, the substrates each having a backside, the support plane dividing the coating chamber into a rear part and a front part of the coating chamber, and the coating device being located in the front part of the coating chamber; and a stray coating prevention device according to any embodiment or example of embodiments described herein, the adsorption traps being provided at at least one element selected from the group consisting of a surface of the coating chamber and a surface of the rear part of the coating chamber.

In some examples of embodiments described herein, the adsorption traps may be arranged in a pattern, for instance in a regular pattern and/or in a pattern of three-dimensional structures. In some embodiments, the adsorption traps may include at least one structure selected from the group consisting of a three-dimensional structure, a three-dimensional structure having a closed bottom, a lamellar structure, a corrugated structure, and a honeycomb structure. For instance, the adsorption traps may include a so called collimator formed e.g. as a honeycomb and having a closed bottom. The three-dimensional structure may be a geometrical structure. Moreover, according to examples of embodiments, the stray coating prevention device may be a backside coating prevention device and the adsorption traps may be adapted to be provided and/or may be provided, respectively, at a surface of the rear part of the coating chamber.

Fig. 1 shows a cross-sectional view of the coating chamber 10 including a stray coating prevention device according to one example of embodiments described herein. In this example, the stray coating prevention device is a backside coating prevention device 200. The backside coating prevention device 200 is therefore provided at a surface of the rear part 72 of the coating chamber 10, in the present example on the front side 31 of the cover panel 36 of the transport system 30.

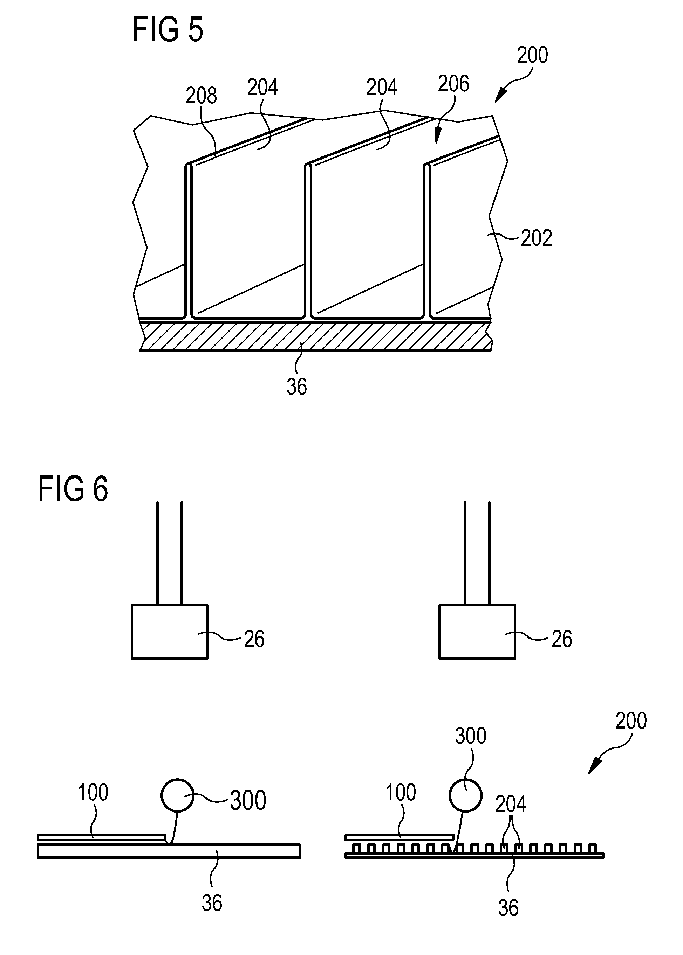

The backside coating prevention device 200 of the present example is shown in more detail in Fig. 5. It includes a profiled or corrugated metal sheet 202 covering the cover panel 36. The metal sheet 202 may be folded as shown in Fig. 5, for providing the profiled or corrugated structure. The material of the metal sheet 202 may for instance include vacuum compatible stainless steel. The folded metal sheet 202 includes a plurality of parallel lamellae 204 resulting in elongated recesses formed of trenches 206.

According to one example, the folded metal sheet 202 may be provided over the whole area of the front side 31 of cover panel 36. For instance, the cover panel 36 and the folded metal sheet 202 may extend over an area in a range of about 800 mm x about 500 mm to about 1000 mm x about 700 mm, typically over an area of about 913 mm x about 607 mm. In order to allow transport of the substrates 100 by the rings 33 which extend through openings 34 in the cover panel 36 of the transport system 30, the folded metal sheet 202 may include openings (not shown) corresponding to the openings 34 of the cover panel 36. Moreover, the folded metal sheet 202 may include holes (not shown) for mounting the folded metal sheet 202 at the cover panel 36.

In another example, the folded metal sheet 202 may include a plurality of folded metal sheets 202 covering the front side 31 of cover panel 36 at regions in which increased backside coating appears, e.g. at the outer perimeter of the cover panel 36.

The thickness of the metal sheet 202 may be, for instance, in a range of about 0.1 mm to about 5 mm. The efficiency of the stray coating prevention device including the metal sheet 202 will increase with decreasing thickness. The recesses formed by the trenches 206 have a depth and a width, in the present example the trench depth and the trench width. The trench depth is the depth of the lamellae 204 and the trench width is the distance from one lamella 204 to the next lamella 204. The recesses or trenches 206, respectively, are separated from each other by fields 208 forming the top of the lamellae 204. The fields 208 have a field width extending from one trench to the adjacent trench. In some examples of embodiments, the field widths, the trench depths and the trench widths are constant over the whole area of the folded metal sheet 202. According to some examples of embodiments, the ratio of trench width to field width is selected from the range of about 2:1 to about 4:1, typically about 2:1, and/or the aspect ratio of the trench depth to trench width is selected from the range of about 16:9 to about 1:1, typically about 3:1 to about 1.2:1, more typically about 4:3. According to some examples of embodiments, the trench depths may be in a range of about 4 mm to about 10 mm, typically about 8 mm, and the trench widths may be in a range of about 3 mm to about 8 mm, typically about 6 mm. In some examples of embodiments, e.g. for solid Al, the field width may be in a range of about 2 mm to about 5 mm, typically about 3 mm. Typical values of the field width may vary from about 0.1 to about 0.5 mm for corrugated steel.

In general, a typical stray coating prevention device of embodiments described herein may include both a very high trench with to trench field ratio and trench depth to trench width ratio.

In some embodiments, the coating device includes an elongated sputtering target and the adsorption traps have an elongated three dimensional structure positioned in parallel to the elongated sputtering target. Hence, in case of continuously or discontinuously transporting the substrates during coating, the elongated three dimensional structure may be provided in parallel to the front edges of the substrates.

According to one example of embodiments, as shown in Figs. 1 and 2, the parallel lamella 204 of the folded metal sheet 202, i.e. its elongated recesses, are oriented in parallel to the elongated target 26. The effect of this arrangement is schematically illustrated in Fig. 6, the arrangement and other features being shown not to scale. Fig. 6 schematically shows in the left side drawing a coating arrangement without the backside coating prevention device 200 and in the right side drawing an arrangement of the present example with the backside coating prevention device 200 including the lamellae 204. As shown in the left side drawing of Fig. 6, a substrate 100 is provided above the cover panel 36 and may be transported below sputtering target 26 from the left to the right. An Ag particle 300 projected onto the front side of cover panel 36 not being provided with the backside coating prevention device 200 may bounce back and adsorb on the backside of the substrate 100. This is avoided or even prevented, as shown in the right side drawing of Fig. 6, by the lamellae 204 of the present example of embodiments, since the Ag particle 300 is trapped at one of the sidewalls of the lamellae 204.

In other examples of embodiments, recesses or three dimensional structures of the stray coating prevention device, e.g. the elongated recesses of the folded metal sheet 202 shown in Figs. 1 and 5, may have another or even random orientation with respect to the elongated sputtering target 26. Such arrangements also result in a trapping of Ag particles travelling inside of the recesses.

Hence, according to embodiments described herein, the stray coating prevention device includes adsorption traps, which may be arranged in a pattern, such as a regular pattern. Further, the adsorption traps may face the support plane 120, may be provided in parallel to the support plane 120, and/or may be provided at the substrate support 30 of the coating chamber 10.

In the example of embodiments as shown in Figs. 1 and 5, the elongated recesses, i.e. the trenches formed by the folded metal sheet 202, act as adsorption traps. Ag particles or atoms travelling in the trenches 206 or bouncing back from the bottom thereof cannot escape from the trenches 206, since they come into contact with surfaces of the trenches or are at least projected towards one of the trench side walls and are adsorbed there. In some examples of embodiments, a ratio of trench width to field width and the selected aspect ratio of the trench depth to trench width may be selected, e.g. maximized, improving the trapping efficiency of the folded metal sheet 202. Moreover, since atoms impinging on the fields 208 of the trenches 206 can not be trapped, the ratio of bottom trench surface to field may be maximized in some examples of embodiments.

Moreover, when using the example of Figs. 1 and 5 including a folded metal sheet 202 as a stray coating prevention device 200, the manufacturing cost may be reduced. Further, the folded metal sheet 202 may be easily exchanged and may be for single use. Alternatively, the folded metal sheet 202 may be cleaned after use, e.g. by an acidic cleaning agent, resulting in an easy recycling procedure. In addition, a cleaning of the cover panel 36 is not required. Furthermore, the folded metal sheet 202 may be easily incorporated in substrate support, cooling and/or substrate backside gas supply arrangements of existing coating chambers.

In some examples of embodiments, the adsorption traps are provided in the rear part of the coating chamber at a distance in the range of about 2 mm to about 10 mm from the support plane. For instance, according to the example shown in Figs. 1 and 5, the fields 208 of the folded metal sheet 202 may be provided at a distance in a range of about 2 mm to about 10 mm, typically at a distance of about 4 mm, from the support plane 120 and the backsides 110 of the substrates 100, respectively. The resulting distance of at least about 2 mm between the stray coating prevention device 200 and the substrate support plane 120 or transported glass substrates 100, respectively, allows for vibrations or sagging of the glass substrates 100 during transport. At the same time, contact or collisions of the glass substrates 100 with the cover panel 36 are avoided.

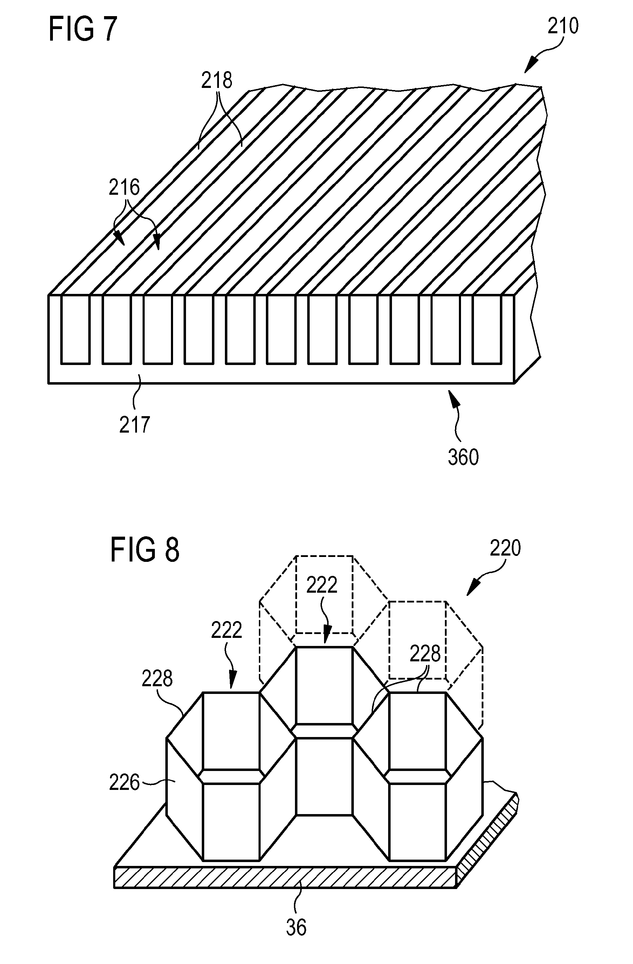

In further examples of embodiments, as a stray coating prevention device 200, instead of the folded metal sheet 202 provided at the cover panel 36 of the transport system 30, as shown in Fig. 1, the cover panel itself may include a plurality of parallel trenches 216 having fields 218. For instance, the trenches 216 may be machined in a cover panel 360 of the transport system 30. An example of such a cover panel 360 is illustrated in Fig. 7. The cover panel 360 may have a total thickness in the range of about 10 mm to about 25 mm, typically about 15 mm. The dimensions of the trenches 216 and the fields 218 may be the same as described above referring to Figs. 1 and 5. Typical values of the field width may vary from 2 mm to about 5 mm for an embodiment formed of a cover panel of solid aluminium including parallel trenches.

In yet further examples of embodiments described herein, the adsorption traps of the stray coating prevention device may include a honeycomb structure. Such an example is illustrated in Fig. 8, schematically showing a section of stray coating prevention device 220 which is a three dimensional honeycomb structure 220 covering the cover panel 36. The honeycomb structure 220 includes a plurality of hexagonal openings 222 forming the adsorption traps. The honeycomb structure 220 has sidewalls 226 provided perpendicularly on a bottom plate 217. The openings 222 are separated from each other by fields 228 forming the top of the sidewalls 226 or of the honeycomb structure 220, respectively. The fields 228 have a field width extending from one opening 222 to the adjacent opening 222. The openings 222 each have an opening width from one sidewall 226 to the opposite sidewall 226. In some examples of embodiments, the field widths, the opening depths and the opening widths are constant over the whole area of the folded metal sheet 202. According to some examples of embodiments, the ratio of opening width to field width is selected from the range of 2:1 to 4:1, typically about 3:1 to about 1.2:1, more typically 2:1, and/or the aspect ratio of the opening depth to opening width is selected from the range of 70:1 to 10:1, typically 25:1. According to some examples of embodiments, the opening depths may be in a range of about 4 mm to about 10 mm, typically about 8 mm to 10 mm, and the opening widths may be in a range of about 3 mm to about 8 mm, typically about 5 mm to about 6 mm. In some examples of embodiments, the field width may be in a range of about 3 mm to about 10 mm, typically about 5 mm to about 6 mm. Typical values of the field width vary from 0.1 mm to 0.2 mm for the honeycomb structure.

The honey comb structure 220 may be mounted on the bottom plate 217, which may have a thickness of approximately 0.5 mm. This assembly, which can be a generic off the shelf product, may then be mounted by attaching the bottom plate 217 on cover panel 36 of the transport system 30. In order to allow transport of the substrates 100 by the rings 33 which extend through openings 34 in the cover panel 36 of the transport system 30, the honey comb structure 220 mounted on the bottom plate 217 may include openings (not shown) corresponding to the openings 34 of the cover panel 36. Such a stray coating prevention device may be intended for single use and can be directly recycled avoiding the need of cleaning cover panel 36.

Moreover, for avoiding stray and/or backside coating of the substrates near lateral gaps 50, which are formed between the lateral sides 114 of the substrates 100 and the sidewalls 17 of the coating chamber 10, as well as at the lateral ends 112 of the substrates, the honey comb structure 220 may be used.

In or more of the above examples of embodiments of the stray coating prevention device including adsorption traps may not only be provided at the cover panel 36, but in addition or exclusively at the side walls 17 of the coating chamber 10, or even at other walls or components of the coating chamber 10. For instance, the example of the stray coating prevention device including adsorption traps arranged in a honeycomb structure may be provided at the sidewalls 17 of the coating chamber and/or at the lateral regions of the cover panel 36, whereas the example of the stray coating prevention device including a lamellar and/or corrugated structure may be provided at the cover panel 36 of the coating chamber 10. Moreover, the above embodiments or examples of embodiments of the stray coating prevention device including adsorption traps may not only be provided in the rear part of the coating chamber, but in addition or exclusively at surfaces in the front part of the coating chamber 10. Thereby, undesired stray coating on the substrates 100 may generally be avoided or prevented during coating operation.

Moreover, when depositing large substrates with a PVD process an electrical field may exist between the substrates 100 and the cover panel 36 that is typically grounded. This electrical field can result in arcing between the substrates 100 and the cover panel 36, commonly known as crazing. When crazing appears on the substrates, sale of the substrates may be difficult or the product has to be either scrapped or reworked if possible and viable. To avoid crazing the strength of the electrical field must be kept to a minimum. This may be done by increasing the distance between the substrates and cover panel 36. As a result, in case of a constant re-sputter angle distribution, the surface area exposed to back side deposition can increase.

However, according to embodiments described herein, the cover panel 36 may include or may be covered by a profiled surface. For instance, in some embodiments, the adsorption traps are provided by at least one element selected from the group consisting of elongated recesses, elongated recesses extending perpendicularly to the transport direction, elongated recesses extending in parallel to the transport direction, a folded sheet provided on the cover panel of the transport system, and folded metal sheet trenches provided on the cover panel of the transport system. Due to the resulting profiled structure of or on the cover panel 36, the electrical capacitance between the substrate backsides and the cover panel structure is reduced, when the distance between the fields of the profiled structure and the substrates 100 is kept constant. The reason for this is that the total field surface area of a profiled cover panel structure is smaller than the field surface area of a planar cover panel. Thus, embodiments described herein allow for a smaller distance between the cover panel structure, e.g. the fields of the profiled structure on or of the cover panel, and the backsides of the substrates, as compared to a case in which a planar cover panel is used. This reduces the backside surface area on which backside deposition can occur.

Hence, the stray coating prevention device according to embodiments described herein may also be used for avoiding stray coating on other areas of the substrate than the backside.

In one embodiment, a method of coating one or more substrates in a coating chamber is provided, including providing a substrate on a substrate support of the coating chamber which is provided with a stray coating prevention device according to any of above examples and embodiments, dispensing coating material from a coating device provided in the coating chamber towards the substrate, and simultaneously preventing stray coating and/or backside coating of the substrate by the stray coating prevention device.

In a further embodiment, a method of coating one or more substrates in a coating chamber is provided, including providing the coating chamber according to any of above examples and embodiments, providing a substrate on the substrate support of the coating chamber, dispensing coating material from the coating device provided in the coating chamber towards the substrate, and simultaneously preventing stray coating and/or backside coating of the substrate by the stray coating prevention device.

In the above methods, the adsorption traps may face the backside of the substrate.

According to some examples, the above methods may include providing the substrate by feeding the substrate into the coating chamber and arranging the substrate on the substrate support, the substrate support being a transport system for continuously or discontinuously transporting the substrate along a transport direction, continuously or discontinuously transporting the substrate by the transport system along the transport direction while dispensing coating material from the coating device and preventing stray coating and/or backside coating of the substrate by the stray coating prevention device, and discharging the substrate from the coating chamber. Such a method may be realized by the method illustrated in Fig. 4, which is performed in the coating chamber 10 including one of the above examples of the stray coating prevention device including adsorption traps, according to embodiments described herein.

In embodiments described herein, the stray coating prevention device includes adsorption traps. The adsorption traps may include a three dimensional structure, which may include recesses. The recesses may be arranged adjacent to each other and may be separated by fields. Ag particles or atoms travelling in the adsorption traps and/or recesses, respectively, or bouncing back from the bottom thereof cannot escape from the adsorption traps, since they come into contact with surfaces of the adsorption traps, or are at least projected towards one of the side walls of the adsorption traps and are adsorbed there. In some examples of embodiments including adsorption traps having recesses, a ratio of recess width to field width and the selected aspect ratio of the recess depth to recess width may be selected which improves the trapping efficiency of the stray coating prevention device. Moreover, since atoms impinging on the field of the recesses can not be trapped, the ratio of recess bottom surface to field may be maximized in some examples of embodiments.

Moreover, when using the stray coating prevention device of embodiments described herein, the manufacturing cost may be reduced. Further, the stray coating prevention device of embodiments described herein may be easily exchanged and/or may be for single use. Alternatively, the stray coating prevention device of embodiments described herein may be cleaned after use, e.g. by an acidic cleaning agent, resulting in an easy recycling procedure. In addition, a cleaning of a cover panel of the substrate support may be not required, when provided with the stray coating prevention device of embodiments described herein. Furthermore, the stray coating prevention device of embodiments described herein may be easily incorporated in substrate support, substrate cooling and/or substrate backside gas supply arrangements of existing coating chambers.

In one embodiment, a stray coating prevention device adapted for a coating chamber for coating substrates is provided, said coating chamber including a coating device adapted for dispensing coating material into the coating chamber; a substrate support adapted to support one or more substrates on a support plane, the substrates each having a backside, the support plane dividing the coating chamber into a rear part and a front part of the coating chamber, and the coating device being located in the front part of the coating chamber; wherein the stray coating prevention device includes a plurality of adsorption traps, the adsorption traps being adapted to be provided at a surface of the coating chamber.

In one embodiment, which may be combined with any other embodiment described herein, the adsorption traps are arranged in a pattern.

In one embodiment, which may be combined with any other embodiment described herein, the adsorption traps are arranged in a regular pattern.

In one embodiment, which may be combined with any other embodiment described herein, the adsorption traps include at least one structure selected from the group consisting of a three-dimensional structure, a three-dimensional structure having a closed bottom, a lamellar structure, a corrugated structure, and a honeycomb structure.

In one embodiment, which may be combined with any other embodiment described herein, the stray coating prevention device is a backside coating prevention device and the adsorption traps are adapted to be provided at a surface of the rear part of the coating chamber.

In one embodiment, a coating chamber for coating substrates is provided, including a coating device adapted for dispensing coating material into the coating chamber; a substrate support adapted to support one or more substrates on a support plane, the substrates each having a backside, the support plane dividing the coating chamber into a rear part and a front part of the coating chamber, and the coating device being located in the front part of the coating chamber; and a stray coating prevention device including a plurality of adsorption traps, the adsorption traps being provided at at least one element selected from the group consisting of a surface of the coating chamber and a surface of the rear part of the coating chamber.

In one embodiment, which may be combined with any other embodiment described herein, the adsorption traps face the support plane.

In one embodiment, which may be combined with any other embodiment described herein, the adsorption traps are provided in parallel to the support plane.

In one embodiment, which may be combined with any other embodiment described herein, the adsorption traps are provided at the substrate support.

In one embodiment, which may be combined with any other embodiment described herein, the adsorption traps are provided on or in at least one element selected from the group consisting of a surface of the coating chamber, a surface of the rear part of the coating chamber, a surface of the rear part of the coating chamber, and a surface of the substrate support.

In one embodiment, which may be combined with any other embodiment described herein, the adsorption traps are provided in the rear part of the coating chamber at a distance in the range of 2 mm to 10 mm from the support plane.

In one embodiment, which may be combined with any other embodiment described herein, the substrate support includes a transport system adapted to transport the one or more substrates on a transport plane and along a transport direction, and wherein the adsorption traps are provided on or in a cover panel of the transport system.

In one embodiment, which may be combined with any other embodiment described herein, the coating device is a sputtering device and/or includes an elongated sputtering target, and the adsorption traps have an elongated three dimensional structure positioned in parallel to the elongated sputtering target.

In one embodiment, which may be combined with any other embodiment described herein, the adsorption traps are provided by at least one element selected from the group consisting of elongated recesses, elongated recesses extending perpendicularly to the transport direction, elongated recesses extending in parallel to the transport direction, a folded sheet provided on the cover panel of the transport system, and folded metal sheet trenches provided on the cover panel of the transport system.

In one embodiment, which may be combined with any other embodiment described herein, the elongated recesses, e.g. trenches, are separated by fields, the recesses having a recess depth and a recess width, the fields having a field width, and wherein the ratio of recess width to field width is selected from the range of 2:1 to 4:1, and/or the aspect ratio of the recess depth to recess width is selected from the range of 16:9 to 1:1.

In one embodiment, a method of coating one or more substrates in a coating chamber is provided, including providing a substrate on a substrate support of the coating chamber, the coating chamber being provided with a stray coating prevention device including a plurality of adsorption traps, the adsorption traps being provided at a surface of the coating chamber; and dispensing coating material from a coating device provided in the coating chamber towards the substrate and simultaneously preventing stray coating of the substrate by the stray coating prevention device.

In one embodiment, a method of coating one or more substrates in a coating chamber is provided, including providing a substrate on a substrate support of the coating chamber, the coating chamber including a coating device adapted for dispensing coating material into the coating chamber and a substrate support adapted to support one or more substrates on a support plane, the substrates each having a backside, the support plane dividing the coating chamber into a rear part and a front part of the coating chamber and a coating device being located in the front part of the coating chamber; the coating chamber being provided with a stray coating prevention device including a plurality of adsorption traps, the adsorption traps being provided at a surface of the rear part of the coating chamber; and dispensing coating material from the coating device towards the substrate and simultaneously preventing backside coating of the substrate by the stray coating prevention device.

In one embodiment, a method of coating one or more substrates in a coating chamber is provided, including providing the coating chamber, the coating chamber being provided with a stray coating prevention device including a plurality of adsorption traps, the adsorption traps being provided at a surface of the coating chamber; providing a substrate on the substrate support of the coating chamber; and dispensing coating material from the coating device provided in the coating chamber towards the substrate and simultaneously preventing stray coating of the substrate by the stray coating prevention device.

In one embodiment, a method of coating one or more substrates in a coating chamber is provided, including providing the coating chamber, the coating chamber including a coating device adapted for dispensing coating material into the coating chamber and a substrate support adapted to support one or more substrates on a support plane, the substrates each having a backside, the support plane dividing the coating chamber into a rear part and a front part of the coating chamber, and the coating device being located in the front part of the coating chamber; the coating chamber being provided with a stray coating prevention device including a plurality of adsorption traps, the adsorption traps being provided at a surface of the rear part of the coating chamber; providing a substrate on the substrate support, dispensing coating material from the coating device towards the substrate, and simultaneously preventing backside coating of the substrate by the stray coating prevention device.

In one embodiment, which may be combined with any other embodiment described herein, the adsorption traps face the backside of the substrate.

In one embodiment, which may be combined with any other embodiment described herein, the method includes providing the substrate by feeding the substrate into the coating chamber and arranging the substrate on the substrate support, the substrate support being a transport system for continuously or discontinuously transporting the substrate along a transport direction, continuously or discontinuously transporting the substrate by the transport system along the transport direction while dispensing coating material from the coating device and preventing backside coating of the substrate by the stray coating prevention device, and discharging the substrate from the coating chamber.

In one embodiment, which may be combined with any other embodiment described herein, the method includes providing the substrate by feeding the substrate into the coating chamber and arranging the substrate on the substrate support, the substrate support being a transport system for continuously or discontinuously transporting the substrate along a transport direction, continuously or discontinuously transporting the substrate by the transport system along the transport direction while dispensing coating material from the coating device and preventing backside coating of the substrate by the stray coating prevention device, and discharging the substrate from the coating chamber.

In one embodiment, which may be combined with any other embodiment described herein, the method includes providing the substrate by feeding the substrate into the coating chamber and arranging the substrate on the substrate support, the substrate support being a transport system for continuously or discontinuously transporting the substrate along a transport direction, continuously or discontinuously transporting the substrate by the transport system along the transport direction while dispensing coating material from the coating device and simultaneously preventing stray coating of the substrate by the stray coating prevention device, and discharging the substrate from the coating chamber.

In one embodiment, which may be combined with any other embodiment described herein, the method includes providing the substrate by feeding the substrate into the coating chamber and arranging the substrate on the substrate support, the substrate support being a transport system for continuously or discontinuously transporting the substrate along a transport direction, continuously or discontinuously transporting the substrate by the transport system along the transport direction while dispensing coating material from the coating device and simultaneously preventing stray coating of the substrate by the stray coating prevention device, and discharging the substrate from the coating chamber.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A stray coating prevention device adapted for a coating chamber for coating substrates,
said coating chamber (10) comprising
a coating device (26) adapted for dispensing coating material into the coating chamber;
a substrate support (30) adapted to support one or more substrates (100) on a support plane (120), the substrates each having a backside (110), the support plane dividing the coating chamber into a rear part (72) and a front part (71) of the coating chamber, and the coating device being located in the front part of the coating chamber;
wherein the stray coating prevention device (200; 210; 220) comprises a plurality of adsorption traps (206; 216; 222), the adsorption traps being adapted to be provided at a surface of the coating chamber.

2. The stray coating prevention device of claim 1,
wherein the adsorption traps are arranged in a pattern.

3. The stray coating prevention device of claim 1 or 2,
wherein the adsorption traps comprise at least one structure selected from the group consisting of a three-dimensional structure, a three-dimensional structure having a closed bottom, a lamellar structure, a corrugated structure, and a honeycomb structure.

4. The stray coating prevention device of any of the preceding claims,
wherein the stray coating prevention device (200; 210; 220) is a backside coating prevention device and the adsorption traps are adapted to be provided at a surface of the rear part of the coating chamber.

5. A coating chamber for coating substrates,
comprising
a coating device (26) adapted for dispensing coating material into the coating chamber;
a substrate support (30) adapted to support one or more substrates on a support plane (120), the substrates each having a backside (110), the support plane dividing the coating chamber into a rear part (72) and a front part (71) of the coating chamber, and the coating device being located in the front part of the coating chamber; and
a stray coating prevention device (200; 210; 220) according to any of claims 1 to 4, the adsorption traps (206; 216; 222) being provided at at least one element selected from the group consisting of a surface of the coating chamber and a surface of the rear part of the coating chamber.

6. The coating chamber of any of the preceding claims,
wherein the adsorption traps face the support plane, and /or
wherein the adsorption traps are provided in parallel to the support plane, and/or
wherein the adsorption traps are provided at the substrate support.

7. The coating chamber of any of the preceding claims,
wherein the adsorption traps are provided on or in at least one element selected from the group consisting of a surface of the coating chamber, a surface of the rear part of the coating chamber, and a surface of the substrate support, and/or
wherein the adsorption traps are provided in the rear part of the coating chamber at a distance in the range of 2 mm to 10 mm from the support plane.

8. The coating chamber of any of the preceding claims,
wherein the substrate support includes a transport system (30) adapted to transport the one or more substrates on a transport plane and along a transport direction, and wherein the adsorption traps are provided on or in a cover panel of the transport system.

9. The coating chamber of any of the preceding claims,
wherein the coating device is a sputtering device and/or includes an elongated sputtering target (26) and the adsorption traps have an elongated three dimensional structure positioned in parallel to the elongated sputtering target.

10. The coating chamber of any of the preceding claims,
wherein the adsorption traps are provided by at least one element selected from the group consisting of elongated recesses, elongated recesses extending perpendicularly to the transport direction, elongated recesses extending in parallel to the transport direction, a folded sheet provided on the cover panel of the transport system, and folded metal sheet trenches provided on the cover panel of the transport system.

11. The coating chamber of claim 10,
wherein the elongated recesses are separated by fields (208; 218; 228), the recesses having a recess depth and a recess width, the fields having a field width, and wherein the ratio of recess width to field width is selected from the range of 2:1 1 to 4:1, and/or the aspect ratio of the recess depth to recess width is selected from the range of 16:9 to 1:1.

12. A method of coating one or more substrates in a coating chamber, comprising
providing a substrate on a substrate support (30) of the coating chamber which is provided with a stray coating prevention device (200; 210; 220) according to any of claims 1 to 4, and
dispensing coating material from a coating device (26) provided in the coating chamber towards the substrate (100) and simultaneously preventing stray coating and/or backside coating of the substrate by the stray coating prevention device.

13. A method of coating one or more substrates in a coating chamber, comprising
providing the coating chamber according to any of claims 5 to 11, providing a substrate on the substrate support (30) of the coating chamber, and
dispensing coating material from the coating device (26) provided in the coating chamber towards the substrate and simultaneously preventing stray coating and/or backside coating of the substrate by the stray coating prevention device.

14. The method according to any of claims 12 or 13, wherein the adsorption traps (206; 216; 222) face the backside of the substrate.

15. The method according to any of claims 12 to 14, comprising
providing the substrate (100) by feeding the substrate into the coating chamber and arranging the substrate on the substrate support (30), the substrate support being a transport system for continuously or discontinuously transporting the substrate along a transport direction, continuously or discontinuously transporting the substrate by the transport system along the transport direction while dispensing coating material from the coating device and simultaneously preventing stray coating and/or backside coating of the substrate by the stray coating prevention device (200; 210; 220), and
discharging the substrate from the coating chamber.

## Amended claims

### Amended claims in accordance with Rule 137(2) EPC.

**1.** A stray coating prevention device adapted for a coating chamber for coating substrates,
said coating chamber (10) comprising
a coating device (26) adapted for dispensing coating material into the coating chamber;
a substrate support (30) adapted to support one or more substrates (100) on a support plane (120), the substrates each having a backside (110), the support plane dividing the coating chamber into a rear part (72) and a front part (71) of the coating chamber, and the coating device being located in the front part of the coating chamber;
wherein the stray coating prevention device (200; 210; 220) comprises a plurality of adsorption traps (206; 216; 222), the adsorption traps being adapted to be provided at a surface of the coating chamber;
wherein the stray coating prevention device (200; 210; 220) is a backside coating prevention device and the adsorption traps are adapted to be provided at a surface of the rear part of the coating chamber at the substrate support.

**2.** The stray coating prevention device of claim 1,
wherein the adsorption traps are arranged in a pattern.

**3.** The stray coating prevention device of claim 1 or 2,
wherein the adsorption traps comprise at least one structure selected from the group consisting of a three-dimensional structure, a three-dimensional structure having a closed bottom, a lamellar structure, a corrugated structure, and a honeycomb structure.

**4.** A coating chamber for coating substrates,
comprising
a coating device (26) adapted for dispensing coating material into the coating chamber;
a substrate support (30) adapted to support one or more substrates on a support plane (120), the substrates each having a backside (110), the support plane dividing the coating chamber into a rear part (72) and a front part (71) of the coating chamber, and the coating device being located in the front part of the coating chamber; and
a stray coating prevention device (200; 210; 220) according to any of claims 1 to 3, the adsorption traps (206; 216; 222) being provided at a surface of the rear part of the coating chamber at the substrate support.

**5.** The coating chamber of any of the preceding claims,
wherein the adsorption traps face the support plane, and /or
wherein the adsorption traps are provided in parallel to the support plane.

**6.** The coating chamber of any of the preceding claims,
wherein the adsorption traps are provided on or in at least one element selected from the group consisting of a surface of the coating chamber, a surface of the rear part of the coating chamber, and a surface of the substrate support, and/or
wherein the adsorption traps are provided in the rear part of the coating chamber at a distance in the range of 2 mm to 10 mm from the support plane.

**7.** The coating chamber of any of the preceding claims,
wherein the substrate support includes a transport system (30) adapted to transport the one or more substrates on a transport plane and along a transport direction, and wherein the adsorption traps are provided on or in a cover panel of the transport system.

**8.** The coating chamber of any of the preceding claims,
wherein the coating device is a sputtering device and/or includes an elongated sputtering target (26) and the adsorption traps have an elongated three dimensional structure positioned in parallel to the elongated sputtering target.

**9.** The coating chamber of any of the preceding claims,
wherein the adsorption traps are provided by at least one element selected from the group consisting of elongated recesses, elongated recesses extending perpendicularly to the transport direction, elongated recesses extending in parallel to the transport direction, a folded sheet provided on the cover panel of the transport system, and folded metal sheet trenches provided on the cover panel of the transport system.

**10.** The coating chamber of claim 9,
wherein the elongated recesses are separated by fields (208; 218; 228), the recesses having a recess depth and a recess width, the fields having a field width, and wherein the ratio of recess width to field width is selected from the range of 2:1 to 4:1, and/or the aspect ratio of the recess depth to recess width is selected from the range of 16:9 to 1:1.

**11.** A method of coating one or more substrates in a coating chamber, comprising
providing a substrate on a substrate support (30) of the coating chamber which is provided with a stray coating prevention device (200; 210; 220) according to any of claims 1 to 3, and
dispensing coating material from a coating device (26) provided in the coating chamber towards the substrate (100) and simultaneously preventing stray coating and/or backside coating of the substrate by the stray coating prevention device.

**12.** The method of claim 11, wherein the substrate is provided on the substrate support (30) of the coating chamber according to any of claims 4 to 10.

**13.** The method according to any of claims 11 or 12, wherein the adsorption traps (206; 216; 222) face the backside of the substrate.

**14.** The method according to any of claims 11 to 13, comprising providing the substrate (100) by feeding the substrate into the coating chamber and arranging the substrate on the substrate support (30), the substrate support being a transport system for continuously or discontinuously transporting the substrate along a transport direction, continuously or discontinuously transporting the substrate by the transport system along the transport direction while dispensing coating material from the coating device and simultaneously preventing stray coating and/or backside coating of the substrate by the stray coating prevention device (200; 210; 220), and discharging the substrate from the coating chamber.
